(19) Europäisches Patentamt / European Patent Office / Office européen des brevets

(11) **EP 4 159 704 B1**

(12) **EUROPEAN PATENT SPECIFICATION**

(45) Date of publication and mention
of the grant of the patent:
**16.04.2025   Bulletin 2025/16**

(21) Application number: **21813874.1**

(22) Date of filing: **24.05.2021**

(51) International Patent Classification (IPC):
*C04B 37/02* (2006.01)   *H05K 1/02* (2006.01)
*C04B 35/645* (2006.01)

(52) Cooperative Patent Classification (CPC):
**C04B 37/026; C04B 35/645; H05K 1/0306;
H05K 3/388;** C04B 2235/6567; C04B 2235/6581;
C04B 2235/661; C04B 2237/12; C04B 2237/122;
C04B 2237/127; C04B 2237/366; C04B 2237/368;
C04B 2237/407; C04B 2237/58; C04B 2237/60;
(Cont.)

(86) International application number:
**PCT/JP2021/019487**

(87) International publication number:
**WO 2021/241463 (02.12.2021 Gazette 2021/48)**

(54) **COPPER/CERAMIC BONDED BODY AND INSULATED CIRCUIT SUBSTRATE**

KUPFER/KERAMIK-VERBUNDKÖRPER UND ISOLIERTES SCHALTUNGSSUBSTRAT

CORPS LIÉ EN CUIVRE/CÉRAMIQUE ET SUBSTRAT DE CIRCUIT ISOLÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.05.2020   JP 2020091953**
**18.05.2021   JP 2021083912**

(43) Date of publication of application:
**05.04.2023   Bulletin 2023/14**

(73) Proprietor: **Mitsubishi Materials Corporation
Tokyo 100-8117 (JP)**

(72) Inventors:
• **TAKAKUWA, Satoshi
Saitama-shi, Saitama 330-8508 (JP)**
• **TERASAKI, Nobuyuki
Saitama-shi, Saitama 330-8508 (JP)**
• **NISHIMOTO, Shuji
Saitama-shi, Saitama 330-8508 (JP)**

(74) Representative: **Hoffmann Eitle
Patent- und Rechtsanwälte PartmbB
Arabellastraße 30
81925 München (DE)**

(56) References cited:
EP-A1- 3 590 909          WO-A1-2018/159590
WO-A1-2019/082970     WO-A1-2019/187767
WO-A1-2020/044593     JP-A- 2010 238 952
JP-A- 2011 124 585        JP-A- 2014 060 215

**(Cont. next page)**

(52) Cooperative Patent Classification (CPC): (Cont.)
C04B 2237/70; H01L 2224/32225

## Description

TECHNICAL FIELD

This invention relates to a copper/ceramic bonded body formed by bonding a copper member, which is formed of copper or a copper alloy, and a ceramic member, as well as an insulated circuit substrate formed by bonding a copper sheet formed of copper or a copper alloy to the surface of a ceramic substrate.

Priority is claimed on Japanese Patent Application No. 2020-091953 filed May 27, 2020, and Japanese Patent Application No. 2021-083912 filed May 18, 2021.

BACKGROUND ART

In power modules, LED modules, and thermoelectric modules, there are structures in which power semiconductor elements, LED elements, and thermoelectric elements are bonded with an insulated circuit substrate on which a circuit layer formed of a conductive material is formed on one surface of an insulating layer.

For example, power semiconductor elements for controlling large amounts of power, which are used to control wind power generation, electric vehicles, hybrid vehicles, and the like, generate a large amount of heat during operation, thus, as a substrate for mounting the above, for example, insulated circuit substrates provided with a ceramic substrate formed of silicon nitride or the like, and a circuit layer formed by bonding a metal sheet with excellent electrical conductivity to one surface of the ceramic substrate are widely used in the related art. Here, there are also insulated circuit substrates on which a metal layer is formed by bonding a metal sheet to the other surface of the ceramic substrate.

For example, Patent Document 1 proposes an insulated circuit substrate in which a circuit layer and a metal layer are formed by bonding copper sheets to one surface and the other surface of a ceramic substrate. In this insulated circuit substrate, copper sheets are arranged to interpose an Ag-Cu-Ti-based brazing material on one surface and the other surface of the ceramic substrate and the copper sheets are bonded by performing a heat treatment (the so-called active metal brazing method).

In addition, Patent Document 2 proposes an insulated circuit substrate in which a copper sheet formed of copper or a copper alloy is bonded with the surface of a ceramic substrate formed of silicon nitride. In this insulated circuit substrate, an active metal and a Mg are arranged between the copper sheet and the ceramic substrate and the ceramic substrate and the copper sheet are bonded by heating the copper sheet and the ceramic substrate in a state of being pressed in the laminating direction.

Patent Document 3 discloses a copper/ceramic joined body in which a copper member made of copper or a copper alloy and a ceramic member made of silicon nitride are joined.

[Citation List]

[Patent Documents]

[Patent Document 1]
Japanese Patent No. 3211856 (B)
[Patent Document 2]
Japanese Unexamined Patent Application, First Publication No. 2018-140929 (A)
[Patent Document 3]
WO 2020/044593 A1

Technical Problem

Here, in a case where a ceramic substrate and a copper sheet are bonded by the active metal brazing method, as disclosed in Patent Document 1, a compound layer of an active metal (Ti) is formed at the bonded interface between the ceramic substrate and the copper sheet. For example, in a case where a ceramic substrate including nitrogen is bonded using an active brazing material including Ti as the active metal, a TiN layer is formed at the bonded interface between the ceramic substrate and the copper sheet.

In addition, in Patent Document 2, an active metal nitride layer including one or two or more active metal nitrides selected from Ti, Zr, Nb, and Hf is formed on the ceramic substrate side between the copper sheet and the ceramic substrate.

Here, in the insulated circuit substrate described above, when a terminal material or the like was ultrasonically welded with the surface of the circuit layer (copper sheet), there were concerns that the copper sheet may be plastically deformed, the active metal nitride layer, such as the hard TiN layer, may be destroyed, and the bonding reliability may be decreased. In addition, there was a concern that breaking starting from the destruction of the TiN layer may occur in the ceramic substrate.

This invention was created in consideration of circumstances described above and has an objective of providing a copper/ceramic bonded body in which a copper member, which is formed of copper or a copper alloy, and a ceramic member are reliably bonded and in which the bonding reliability is excellent even when ultrasonic waves are applied thereto, as well as an insulated circuit substrate.

Solution to Problem

In order to solve these problems and achieve the objective, the present inventors obtained the following findings as a result of intensive investigation. The invention is defined in the appended claims 1-4.

When a ceramic substrate and a copper sheet are heated to be bonded, the crystal grains of the copper sheet are coarsened. In a case where the crystal grains are coarsened in a region adjacent to an active metal nitride layer such as a TiN layer, it is understood that the region in the vicinity of the bonded interface of the copper sheet is easily deformed when ultrasonic waves are applied thereto and active metal nitride layers such as a TiN layer are destroyed.

The present invention was created based on the findings described above and a copper/ceramic bonded body of an aspect of the present invention is a copper/ceramic bonded body formed by bonding a copper member, which is formed of copper or a copper alloy, and a ceramic member, in which, a ratio $D1/D0$ is 0.60 or less, $D0$ being an average crystal grain size of the entire copper member, $D1$ being an average crystal grain size of the copper member at a position 50 $\mu$m from a bonding surface with the ceramic member, $D0$ and $D1$ being obtained by observing a cross-section of the copper member along a laminating direction.

In the copper/ceramic bonded body with this configuration, when a cross-sectional surface of the copper member in a laminating direction is observed, a ratio $D1/D0$ of an average crystal grain size $D1$ at a position of 50 $\mu$m in the laminating direction from the bonding surface between the copper member and the ceramic member to an average crystal grain size $D0$ of the entire copper member is 0.60 or less, thus, the crystal grain size in the vicinity of the bonded interface is suppressed to be comparatively small, it is possible to suppress deformation of the copper member in the region in the vicinity of the bonded interface when ultrasonic waves are applied thereto, and it is possible to suppress the destruction of the active metal nitride layer such as a TiN layer. In addition, the crystal grain size is not significantly different between the entire copper member and in the vicinity of the bonded interface and it is possible to suppress the hardening of the entire copper member.

Here, in the copper/ceramic bonded body of the present aspect, preferably, Mg is diffused in a region in the copper member, the region being at least 50 $\mu$m from the bonding surface with the ceramic member in the laminating direction, and Mg concentration decreases with increasing a distance from the bonding surface.

In such a case, Mg is sufficiently diffused in a region of the copper member from the bonding surface with the ceramic member to at least 50 $\mu$m in the laminating direction and it is possible to make the crystal grain size in the vicinity of the bonded interface comparatively small.

An insulated circuit substrate of an aspect of the present invention is an insulated circuit substrate formed by bonding a copper sheet, which is formed of copper or a copper alloy, with a surface of a ceramic substrate, in which, a ratio $D1/D0$ is 0.60 or less, $D0$ being an average crystal grain size of the entire copper sheet, $D1$ being an average crystal grain size of the copper sheet at a position 50 $\mu$m from a bonding surface with the ceramic substrate, $D0$ and $D1$ being obtained by observing a cross-section of the copper sheet along a laminating direction.

In the insulated circuit substrate with this configuration, when a cross-sectional surface of the copper sheet in a laminating direction is observed, a ratio $D1/D0$ of an average crystal grain size $D1$ at a position of 50 $\mu$m in the laminating direction from the bonding surface between the copper sheet and the ceramic substrate to an average crystal grain size $D0$ of the entire copper sheet is 0.60 or less, thus, it is possible to suppress the crystal grain size in the vicinity of the bonded interface to be comparatively small, to suppress deformation of the copper sheet in the region in the vicinity of the bonded interface when ultrasonic waves are applied thereto, and to suppress destruction of the active metal nitride layer such as a TiN layer. In addition, the crystal grain size does not differ significantly between the entire copper sheet and in the vicinity of the bonded interface and it is possible to suppress the hardening of the entire copper sheet.

Here, in the insulated circuit substrate of the present aspect, preferably, Mg is diffused in a region in the copper sheet, the region being at least 50 $\mu$m from the bonding surface with the ceramic substrate in the laminating direction, and Mg concentration decreases with increasing a distance from the bonding surface.

In such a case, Mg is sufficiently diffused in a region of the copper sheet from the bonding surface with the ceramic substrate to at least 50 $\mu$m in the laminating direction and it is possible to make the crystal grain size in the vicinity of the bonded interface comparatively small.

## EP 4 159 704 B1

Advantageous Effects of Invention

According to the present invention, it is possible to provide a copper/ceramic bonded body in which a copper member, which is formed of copper or a copper alloy, and a ceramic member are reliably bonded and in which the bonding reliability is excellent even when ultrasonic waves are applied thereto, as well as an insulated circuit substrate.

BRIEF DESCRIPTION OF DRAWINGS

Fig. 1 is a schematic illustration of a power module using an insulated circuit substrate of an embodiment of the present invention.
Fig. 2 is a schematic diagram of the bonded interface between the circuit layer (copper member) and metal layer (copper member) and the ceramic substrate (ceramic member) of the insulated circuit substrate of an embodiment of the present invention.
Fig. 3 is a flow diagram showing a method for manufacturing an insulated circuit substrate of an embodiment of the present invention.
Fig. 4 is an illustration showing the method for manufacturing an insulated circuit substrate of an embodiment of the present invention.
Fig. 5 is a diagram showing observation results of the crystal grain size of a copper sheet in an Example.

DESCRIPTION OF EMBODIMENTS

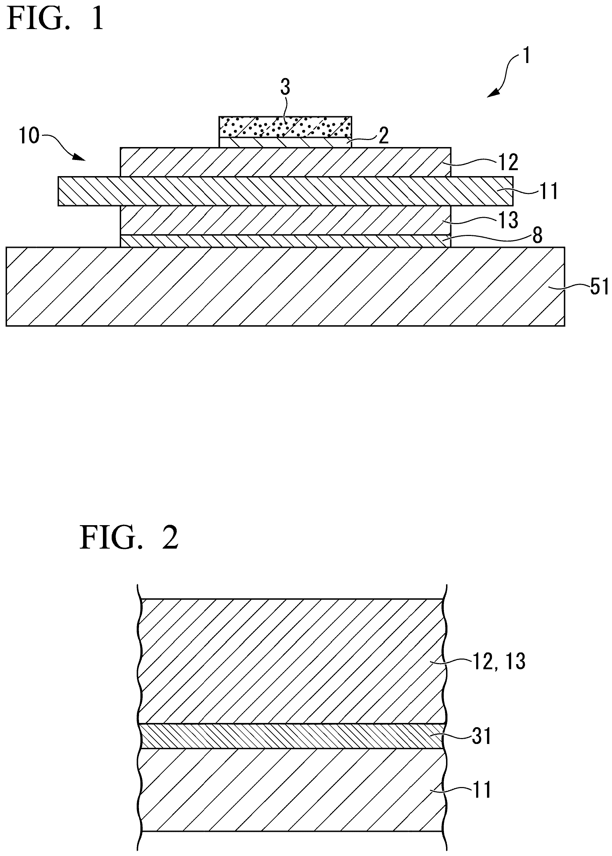

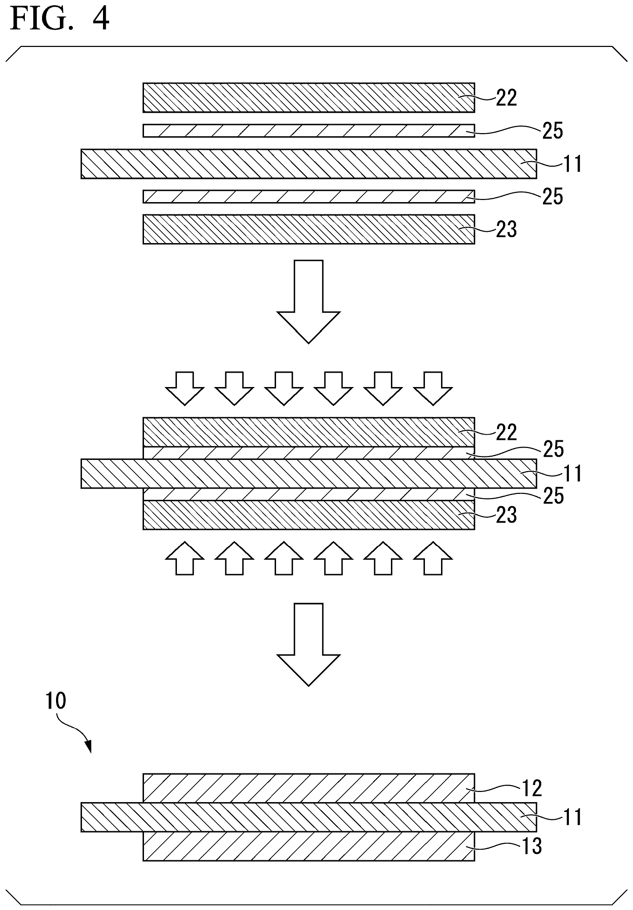

A description will be given below of embodiments of the present invention with reference to the accompanying drawings.
A description will be given of embodiments of the present invention with reference to Fig. 1 to Fig. 4.
The copper/ceramic bonded body according to the present embodiment is an insulated circuit substrate 10 formed by bonding a ceramic substrate 11, which is a ceramic member, with a copper sheet 22 (a circuit layer 12) and a copper sheet 23 (a metal layer 13), which are copper members.
Fig. 1 shows the insulated circuit substrate 10 of an embodiment of the present invention and a power module 1 using this insulated circuit substrate 10.
The power module 1 is provided with the insulated circuit substrate 10, a semiconductor element 3 bonded with one side of the insulated circuit substrate 10 (the upper side in Fig. 1) via a first solder layer 2, and a heat sink 51 bonded with the other side of the insulated circuit substrate 10 (the lower side in Fig. 1) via a second solder layer 8.
The insulated circuit substrate 10 is provided with the ceramic substrate 11, the circuit layer 12 arranged on one surface (the upper surface in Fig. 1) of the ceramic substrate 11, and the metal layer 13 arranged on the other surface (the lower surface in Fig. 1) of the ceramic substrate 11.
The ceramic substrate 11 prevents electrical connection between circuit layer 12 and metal layer 13 and is formed of AlN (aluminum nitride), $Si_3N_4$ (silicon nitride), $Al_2O_3$ (alumina), or the like with excellent insulation properties. In particular, the ceramic substrate 11 is preferably formed of $Si_3N_4$ (silicon nitride), which has excellent strength. Here, the thickness of the ceramic substrate 11 is preferably in a range of 0.2 mm or more and 1.5 mm or less and, in the present embodiment, may be set to 0.32 mm, for example.
As shown in Fig. 4, the circuit layer 12 is provided by bonding the copper sheet 22 formed of copper or a copper alloy with one surface of the ceramic substrate 11. In the present embodiment, a rolled sheet of oxygen-free copper is used as the copper sheet 22 forming the circuit layer 12. A circuit pattern is provided on this circuit layer 12 and one surface thereof (the upper surface in Fig. 1) is the mounting surface on which the semiconductor element 3 is mounted. Here, the thickness of the circuit layer 12 is preferably in a range of 0.1 mm or more and 2.0 mm or less and, in the present embodiment, for example, may be set to 0.6 mm.
As shown in Fig. 4, the metal layer 13 is formed by bonding the copper sheet 23 formed of copper or a copper alloy with the other surface of the ceramic substrate 11. In the present embodiment, a rolled sheet of oxygen-free copper is used as the copper sheet 23 forming the metal layer 13. Here, the thickness of the metal layer 13 is preferably in a range of 0.1 mm or more and 2.0 mm or less and, in the present embodiment, for example, may be set to 0.6 mm.
The heat sink 51 is for cooling the insulated circuit substrate 10 described above and, in the present embodiment, is a heat-dissipating sheet formed of a material with favorable thermal conductivity. In the present embodiment, the heat sink 51 is formed of copper or a copper alloy with excellent thermal conductivity. The heat sink 51 and the metal layer 13 of the insulated circuit substrate 10 are bonded via the second solder layer 8.
Here, the ceramic substrate 11 and the circuit layer 12 (copper sheet 22) as well as the ceramic substrate 11 and the metal layer 13 (copper sheet 23) are bonded via a Mg-Ti-based bonding material 25 as shown in Fig. 4.

At the bonded interface between the ceramic substrate 11 and the circuit layer 12 (the copper sheet 22) and the bonded interface between the ceramic substrate 11 and the metal layer 13 (the copper sheet 23), a TiN layer 31 is provided as shown in Fig. 2. This TiN layer 31 is created by a reaction between the Ti included in the Mg-Ti-based bonding material 25 and the nitrogen (N) included in the ceramic substrate 11.

In the present embodiment, when a cross-sectional surface of the circuit layer 12 (the copper sheet 22) and the metal layer 13 (the copper sheet 23) in a laminating direction is observed, a ratio D1/D0 of an average crystal grain size D1 at a position of 50 $\mu$m in the laminating direction from the bonding surface with the ceramic substrate 11 to an average crystal grain size D0 of the entirety of the circuit layer 12 (the copper sheet 22) and the metal layer 13 (the copper sheet 23) is 0.60 or less and preferably in a range of 0.25 or more and 0.56 or less.

That is, the crystal grain size of the circuit layer 12 (the copper sheet 22) and metal layer 13 (the copper sheet 23) is locally smaller at a position of 50 $\mu$m in the laminating direction from the bonding surface of ceramic substrate 11.

In the present embodiment, the bonding surface of the circuit layer 12 with the ceramic substrate 11 is the uppermost surface of the circuit layer 12 side of the ceramic substrate 11 in the laminating direction.

In addition, in the present embodiment, the bonding surface of the metal layer 13 with the ceramic substrate 11 is the uppermost surface of the metal layer 13 side of the ceramic substrate 11 in the laminating direction.

In the region from the bonding surface with ceramic substrate 11 to 50 $\mu$m in the laminating direction, the TiN layer 31 is interposed between the ceramic substrate 11 and the circuit layer 12 and between the ceramic substrate 11 and the metal layer 13, but the TiN layer 31 is sufficiently thin compared to the circuit layer 12 and the metal layer 13.

The circuit layer 12 and the metal layer 13 are bonded with the ceramic substrate 11 via the TiN layer 31.

The average crystal grain sizes D0 and D1 in the present embodiment are the average crystal grain sizes of the crystal grains including twin crystals.

Here, in the present embodiment, preferably, Mg is diffused in a region of the circuit layer 12 (the copper sheet 22) and the metal layer 13 (the copper sheet 23) from the bonding surface of the ceramic substrate 11 to at least 50 $\mu$m in the laminating direction and the Mg concentration decreases with increasing a distance from the bonding surface. That is, preferably, the Mg in the Mg-Ti-based bonding material 25 is sufficiently diffused to the circuit layer 12 (the copper sheet 22) side and the metal layer 13 (the copper sheet 23) side. The concentration of Mg in this region is preferably 0.1 wt% or more and 10 wt% or less.

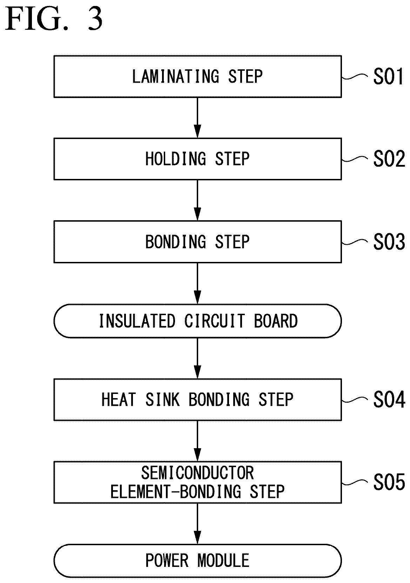

Next, a description will be given of the method for manufacturing the insulated circuit substrate 10 of the present embodiment described above and the power module 1 with reference to Fig. 3 and Fig. 4.

(Laminating Step S01)

As shown in Fig. 4, the Mg-Ti-based bonding material 25 is arranged between the copper sheet 22 which is the circuit layer 12 and the ceramic substrate 11 and between the copper sheet 23 which is the metal layer 13 and the ceramic substrate 11 and the above are laminated. In the present embodiment, a paste material including titanium hydride powder and magnesium hydride powder is used as the Mg-Ti-based bonding material 25. Since titanium and magnesium are active metals, the use of titanium hydride powder and magnesium hydride powder makes it possible to suppress oxidation and the like of titanium and magnesium.

Here, the Mg-Ti-based bonding material 25 to be arranged preferably has a Ti amount in a range of 0.1 $\mu$m or more and 5 $\mu$m or less in terms of thickness and an Mg amount in a range of 1.5 $\mu$m or more and 10 $\mu$m or less.

(Holding Step S02)

Next, the copper sheet 22, the ceramic substrate 11, and the copper sheet 23, which are laminated, are pressed in the laminating direction, charged into a heating furnace, heated, and held at a predetermined holding temperature for a set time.

Here, in the present embodiment, the pressing load in the holding step S02 is preferably in a range of 0.049 MPa or more and 3.4 MPa or less. In addition, the inside of the heating furnace is preferably an inert gas atmosphere such as Ar.

The holding temperature is preferably in a range of 300°C or higher and 730°C or lower and the holding time at the holding temperature is preferably in a range of 10 minutes or more and 120 minutes or less.

By this holding step S02, the Mg of the Mg-Ti-based bonding material 25 is sufficiently diffused toward the copper sheet 22 that will become the circuit layer 12 and the copper sheet 23 that will become the metal layer 13.

(Bonding Step S03)

Next, after the holding step S02, the copper sheet 22, the ceramic substrate 11, and the copper sheet 23, which are laminated, are further heated in a state of being pressed in the laminating direction to bond the copper sheet 22, the ceramic substrate 11, and the copper sheet 23. In this bonding step S03, it is preferable to create a vacuum atmosphere in the heating furnace.

Here, the pressing load in the bonding step S03 is set in a range of 0.049 MPa or more and 3.4 MPa or less.

In addition, the heating temperature in the bonding step S03 is preferably in a range of 650°C or higher and 1050°C or lower.

Furthermore, the holding time at the heating temperature is preferably in a range of 10 minutes or more and 240 minutes or less.

In addition, the vacuum level in the bonding step S03 is preferably in a range of $1 \times 10^{-6}$ Pa or more and $1 \times 10^{-2}$ Pa or less.

As described above, the insulated circuit substrate 10 of the present embodiment is manufactured by the laminating step S01, the holding step S02, and the bonding step S03.

(Heat Sink Bonding Step S04)

Next, the heat sink 51 is bonded with the other surface side (the opposite side to the ceramic substrate 11) of the metal layer 13 of the insulated circuit substrate 10. In the present embodiment, the insulated circuit substrate 10 and the heat sink 51 are laminated via the solder material and charged into a heating furnace and the insulated circuit substrate 10 and the heat sink 51 are solder-bonded via the second solder layer 8.

(Semiconductor Element-Bonding Step S05)

Next, the semiconductor element 3 is bonded with one surface side (the opposite side to the ceramic substrate 11) of the circuit layer 12 of the insulated circuit substrate 10 by soldering.

The power module 1 shown in Fig. 1 is produced by the above steps.

According to the insulated circuit substrate 10 (the copper/ceramic bonded body) of the present embodiment formed as described above, when a cross-sectional surface of the circuit layer 12 and the metal layer 13 in a laminating direction is observed, a ratio D1/D0 of an average crystal grain size D1 at a position of 50 $\mu$m in the laminating direction from the bonding surface with the ceramic substrate 11 to an average crystal grain size D0 of the entirety of the circuit layer 12 and the metal layer 13 is 0.6 or less. Therefore, it is possible to suppress the crystal grain size in the vicinity of the bonded interface to be comparatively small, to suppress deformation of the circuit layer 12 and metal layer 13 in the region in the vicinity of the bonded interface when ultrasonic waves are applied thereto, and to suppress destruction of the TiN layer 31. In addition, the crystal grain size is not significantly different in the vicinity of the bonded interface between the entire circuit layer 12 and the metal layer 13 and it is possible to suppress the hardening of the entire circuit layer 12 and metal layer 13.

Furthermore, in the present embodiment, Mg is sufficiently diffused in a region of the circuit layer 12 and metal layer 13 from the bonding surface of the ceramic substrate 11 to at least 50 $\mu$m in the laminating direction and it is possible to make the crystal grain size in the vicinity of the bonded interface of the circuit layer 12 and metal layer 13 comparatively small.

Although the embodiments of the present invention were described above, the present invention is not limited thereto and appropriate modification is possible in a range not departing from the scope of the invention.

For example, the copper sheet forming the circuit layer or metal layer was described as a rolled sheet of oxygen-free copper, but is not limited thereto and may be formed of other copper or copper alloys.

In addition, it is also possible to carry out the manufacturing using a foil material as the bonding material instead of a paste material.

Furthermore, a description was given of a heat sink with a heat-dissipating sheet as an example; however, the heat sink is not limited thereto and there is no particular limitation on the structure of the heat sink. For example, the heat sink may have a passage through which a refrigerant circulates or may be provided with cooling fins. In addition, it is also possible to use a composite material (for example, AlSiC or the like) including aluminum or aluminum alloys as a heat sink.

In addition, a buffer layer formed of aluminum or a composite material (for example, AlSiC or the like) including aluminum alloys or aluminum may be provided between the top plate portion of the heat sink or the heat-dissipating sheet, and the metal layer.

In addition, in the present embodiment, a description was given of forming a power module by mounting a power semiconductor element on the circuit layer of the insulated circuit substrate; however, the power module is not limited thereto. For example, an LED module may be formed by mounting an LED element on the insulated circuit substrate, or a thermoelectric module may also be formed by mounting a thermoelectric element on the circuit layer of an insulated circuit substrate.

EXAMPLES

A description will be given of confirmatory experiments performed to confirm the effectiveness of the present invention.

A copper sheet (37 mm × 37 mm, thickness of 0.8 mm) was bonded with both surfaces of a ceramic substrate (40 mm × 40 mm, thickness of 0.32 mm) shown in Table 1 using the bonding material shown in Table 1 and an insulated circuit substrate (copper/ceramic bonded body) on which a circuit layer and metal layer were formed was obtained. The holding step and bonding step were carried out under the conditions shown in Table 1. In addition, the vacuum level of the vacuum furnace during bonding was $5 \times 10^{-3}$ Pa.

The insulated circuit substrates (copper/ceramic bonded bodies) obtained in this manner were observed in a cross-sectional surface in the laminating direction and the crystal grain sizes of the circuit layer and metal layer were measured. In addition, ultrasonic waves were applied thereto and peeling at the bonded interface and cracking of the ceramic substrate were evaluated.

(Crystal Grain Size)

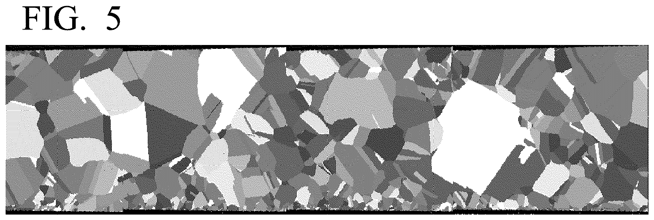

In the cross-sectional surface in the laminating direction of the insulated circuit substrate (circuit layer and metal layer), an average crystal grain size D0 of the entire circuit layer and the entire metal layer was measured using an EBSD measuring device. Fig. 5 shows the observation results of the crystal structure.

In addition, the average crystal grain size D1 at a position of 50 $\mu$m from the uppermost surface of the ceramic substrate to the circuit layer side and the metal layer side was calculated using the equation below by drawing a reference line parallel to the bonded interface at a position separated by 50 $\mu$m in the laminating direction from the bonded interface of the circuit layer and the metal layer with the ceramic substrate and using the number of particles N touching the reference line and the length L of the reference line. The length L of the reference line was as shown in Table 2.

$$D1 = 1.5 \times L/N$$

This measurement was performed for each of the circuit layer and the metal layer and the average values thereof are shown in Table 2.

(Peeling of Bonded interface and Cracking of Ceramic Substrate during Ultrasonic Wave Application)

Terminal materials were ultrasonically welded under conditions of a bonding area of 3 × 3 mm$^2$, a bonding time of approximately 0.6 seconds, and a sinking amount of 0.45 mm and the presence or absence of peeling at the copper/-ceramic substrate bonded interface and cracking in the ceramic substrate was confirmed by ultrasonic flaw detection (SAT).

This confirmation was performed for each of the circuit layer and the metal layer and a case in which peeling of the bonded interface and cracking of the ceramic substrate were confirmed in either was set as "Yes" and a case in which neither was confirmed was set as "No" and listed in Table 2.

(Mg Diffusion Distance)

For the insulated circuit substrate (copper/ceramic bonded body), line analysis of Mg was performed using EPMA for a cross-sectional surface in the laminating direction from the bonding surface of the circuit layer (metal layer) with the ceramic substrate to the surface side of the circuit layer (metal layer). The distance from the bonding surface of the circuit layer (metal layer) with the ceramic substrate to the location where the concentration of Mg was 0.1 wt% was set as the Mg diffusion distance. This measurement was performed at five locations in each of the circuit layer and metal layer and the average values are listed in Table 2.

[Table 1]

| | Bonding material (converted thickness) | | | Ceramic substrate | Holding step | | Bonding step | |
|---|---|---|---|---|---|---|---|---|
| | Mg ($\mu$m) | Ti ($\mu$m) | Shape | Substance | Temperature (°C) | Time (min) | Temperature (°C) | Time (min) |
| Invention example 1 | 3.0 | 0.1 | Paste | $Si_3N_4$ | 600 | 30 | 750 | 100 |
| Invention example 2 | 3.0 | 0.0 | Foil | AlN | 600 | 30 | 850 | 30 |

(continued)

| | Bonding material (converted thickness) | | | Ceramic substrate | Holding step | | Bonding step | |
|---|---|---|---|---|---|---|---|---|
| | Mg (μm) | Ti (μm) | Shape | Substance | Temperature (°C) | Time (min) | Temperature (°C) | Time (min) |
| Invention example 3 | 10.0 | 0.0 | Foil | AlN | 600 | 30 | 850 | 30 |
| Invention example 4 | 6.0 | 0.0 | Paste | AlN | 600 | 30 | 850 | 30 |
| Comparative example | Ag: 5.0 | 1.0 | Paste | $Si_3N_4$ | 600 | 30 | 850 | 30 |

[Table 2]

| | Average crystal grain size (including twin crystals) | | | | | Mg diffusion distance (μm) | Ultrasonic wave application test | |
|---|---|---|---|---|---|---|---|---|
| | Particle number* N (particles) | Reference line length L (μm) | Interface vicinity D1 (μm) | Entirety D0 (μm) | D1/ D0 | | Presence or absence of ceramic cracking | Presence or absence of bonded interface cracking |
| Invention example 1 | 21 | 1200 | 86 | 341 | 0.25 | 50 | No | No |
| Invention example 2 | 66 | 4000 | 91 | 223 | 0.41 | 86 | No | No |
| Invention example 3 | 62 | 4000 | 97 | 172 | 0.56 | 98 | No | No |
| Invention example 4 | 82 | 4000 | 73 | 271 | 0.27 | 92 | No | No |
| Comparative example | 37 | 4000 | 162 | 250 | 0.65 | 58 | No | Yes |

\* Number of particles touching reference line set at position of 50 μm from interface to copper sheet side

In the Comparative Example, the ratio D1/D0 of the average crystal grain size D1 at a position of 50 μm in the laminating direction from the bonding surface of the circuit layer and the metal layer with the ceramic substrate to the average crystal grain size D0 of the entire circuit layer and metal layer was 0.65 and cracking was generated at the bonded interface when ultrasonic waves were applied thereto. This is assumed to be because Ag-Ti paste was used as the bonding material, the crystal grains in the vicinity of the bonded interface were not sufficiently refined, and it was not possible to suppress deformation in the region in the vicinity of the bonded interface in the circuit layer and metal layer when ultrasonic waves were applied thereto.

In Invention Examples 1 to 4, the ratio D1/D0 of the average crystal grain size D1 at a position of 50 μm in the laminating direction from the bonding surface of the ceramic substrate with the circuit layer and the metal layer to the average crystal grain size D0 of the entire circuit layer and metal layer was 0.60 or less and it was possible to suppress the generation of cracking at the bonded interface when ultrasonic waves were applied thereto. This is assumed to be because material containing Mg was used as the bonding material, Mg was diffused to the circuit layer side and metal layer side by further carrying out the holding step and bonding step shown in Table 1 such that the crystal grains in the vicinity of the bonded interface were sufficiently refined and it was possible to suppress deformation in the region in the vicinity of the bonded interface in the circuit layer and metal layer when ultrasonic waves were applied thereto.

From the above, it was confirmed that, according to the Invention Examples, it is possible to provide a copper/ceramic bonded body in which a copper member, which is formed of copper or a copper alloy, and a ceramic member are reliably bonded and the bonding reliability is excellent even when ultrasonic waves are applied thereto, as well as an insulated circuit substrate.

[Reference Signs List]

> 10: Insulated circuit substrate
> 11: Ceramic substrate
> 12: Circuit layer
> 13: Metal layer
> 31: TiN layer

**Claims**

1. A copper/ceramic bonded body formed by bonding a copper member, which is formed of copper or a copper alloy, and a ceramic member,
   wherein a ratio D1/D0 is 0.60 or less, D0 being an average crystal grain size of the entire copper member, D1 being an average crystal grain size of the copper member at a position 50 $\mu$m from a bonding surface with the ceramic member, D0 and D1 being obtained by observing a cross-section of the copper member along a laminating direction.

2. The copper/ceramic bonded body according to Claim 1,
   wherein Mg is diffused in a region in the copper member, the region being at least 50 $\mu$m from the bonding surface with the ceramic member in the laminating direction, and Mg concentration decreases with increasing a distance from the bonding surface.

3. An insulated circuit substrate formed by bonding a copper sheet formed of copper or a copper alloy to a surface of a ceramic substrate,
   wherein a ratio D1/D0 is 0.60 or less, D0 being an average crystal grain size of the entire copper sheet, D1 being an average crystal grain size of the copper sheet at a position 50 $\mu$m from a bonding surface with the ceramic substrate, D0 and D1 being obtained by observing a cross-section of the copper sheet along a laminating direction.

4. The insulated circuit substrate according to Claim 3,
   wherein Mg is diffused in a region in the copper sheet, the region being at least 50 $\mu$m from the bonding surface with the ceramic substrate in the laminating direction, and Mg concentration decreases with increasing a distance from the bonding surface.

**Patentansprüche**

1. Kupfer/Keramik-Verbindungskörper, der aus einem Kupferelement, das aus Kupfer oder einer Kupferlegierung gebildet ist, und einem Keramikelement gebildet ist,
   wobei ein Verhältnis D1/D0 0,60 oder weniger beträgt, wobei D0 eine durchschnittliche Kristallkorngröße des gesamten Kupferelements ist, wobei DI eine durchschnittliche Kristallkorngröße des Kupferelements an einer Position ist, die 50 $\mu$m von der Verbindungsoberfläche mit dem Keramikelement entfernt ist, wobei D0 und D1 durch Betrachtung des Querschnitts des Kupferelements entlang einer Laminierungsrichtung erhalten werden.

2. Kupfer/Keramik-Verbindungskörper gemäß Anspruch 1,
   wobei Mg in einen Bereich in dem Kupferelement diffundiert ist, wobei der Bereich mindestens 50 $\mu$m von der Verbindungsoberfläche mit dem Keramikelement in der Laminierungsrichtung entfernt ist und die Mg-Konzentration mit zunehmender Entfernung von der Verbindungsoberfläche abnimmt.

3. Isoliertes Schaltungssubstrat, das durch Binden eines Kupferblechs, das aus Kupfer oder einer Kupferlegierung gebildet ist, an eine Oberfläche eines Keramiksubstrats gebildet wird,

wobei ein Verhältnis D1/D0 0,60 oder weniger beträgt, wobei D0 eine durchschnittliche Kristallkorngröße des gesamten Kupferblechs ist, wobei D1 eine durchschnittliche Kristallkorngröße des Kupferblechs an einer Position ist, die 50 $\mu$m von der Verbindungsoberfläche mit dem Keramiksubstrat entfernt ist, wobei D0 und D1 durch Betrachtung des Querschnitts des Kupferblechs entlang einer Laminierungsrichtung erhalten werden.

4.  Isoliertes Schaltungssubstrat gemäß Anspruch 3,
    wobei Mg in einen Bereich in dem Kupferblech diffundiert ist, wobei der Bereich mindestens 50 $\mu$m von der Verbindungsoberfläche mit dem Keramiksubstrat in der Laminierungsrichtung entfernt ist und die Mg-Konzentration mit zunehmender Entfernung von der Verbindungsoberfläche abnimmt.


**Revendications**

1.  Corps lié cuivre/céramique formé par liaison d'un élément en cuivre, qui est formé de cuivre ou d'un alliage de cuivre, et d'un élément en céramique,
    dans lequel un rapport D1/D0 est de 0,60 ou moins, D0 étant une taille de grain cristallin moyenne de l'ensemble de l'élément en cuivre, D1 étant une taille de grain cristallin moyenne de l'élément en cuivre à une position de 50 $\mu$m à partir d'une surface de liaison avec l'élément en céramique, D0 et D1 étant obtenus en observant une section transversale de l'élément en cuivre le long d'une direction de stratification.

2.  Corps lié cuivre/céramique selon la revendication 1,
    dans lequel du Mg est diffusé dans une région de l'élément en cuivre, la région étant à au moins 50 $\mu$m de la surface de liaison avec l'élément en céramique dans la direction de stratification, et la concentration de Mg diminue avec l'augmentation de la distance par rapport à la surface de liaison.

3.  Substrat de circuit isolé formé par liaison d'une feuille de cuivre formée de cuivre ou d'un alliage de cuivre à une surface d'un substrat de céramique,
    dans lequel un rapport D1/D0 est de 0,60 ou moins, D0 étant une taille de grain cristallin moyenne de la feuille de cuivre entière, D1 étant une taille de grain cristallin moyenne de la feuille de cuivre à une position de 50 $\mu$m à partir d'une surface de liaison avec le substrat de céramique, D0 et D1 étant obtenus en observant une section transversale de la feuille de cuivre le long d'une direction de stratification.

4.  Substrat de circuit isolant selon la revendication 3,
    dans lequel le Mg est diffusé dans une région de la feuille de cuivre, la région étant à au moins 50 $\mu$m de la surface de liaison avec le substrat de céramique dans la direction de stratification, et la concentration en Mg diminue avec l'augmentation de la distance par rapport à la surface de liaison.

FIG. 1

FIG. 2

# FIG. 3

```
┌─────────────────────────────┐
│      LAMINATING STEP         │ ── S01
└─────────────────────────────┘
              │
              ▼
┌─────────────────────────────┐
│       HOLDING STEP           │ ── S02
└─────────────────────────────┘
              │
              ▼
┌─────────────────────────────┐
│       BONDING STEP           │ ── S03
└─────────────────────────────┘
              │
              ▼
(    INSULATED CIRCUIT BOARD    )
              │
              ▼
┌─────────────────────────────┐
│    HEAT SINK BONDING STEP    │ ── S04
└─────────────────────────────┘
              │
              ▼
┌─────────────────────────────┐
│        SEMICONDUCTOR         │ ── S05
│    ELEMENT-BONDING STEP      │
└─────────────────────────────┘
              │
              ▼
(          POWER MODULE         )
```

# FIG. 4

FIG. 5

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020091953 A
- JP 2021083912 A
- JP 3211856 B
- JP 2018140929 A
- WO 2020044593 A1